# EUROPEAN PATENT APPLICATION

(11) **EP 4 529 388 A1**
(43) Date of publication of application: **26.03.2025**
(21) Application number: 24191723.6
(22) Date of filing: 30.07.2024
(51) Int. Cl.: H10F 10/14, H10F 10/166, H10F 71/00, H10F 77/164, H10F 77/30, H10F 77/70

(54) **SOLAR CELL, METHOD FOR PREPARING SAME AND ELECTRICAL DEVICE**

(30) Priority: 25.09.2023 CN 202311244504
(71) Applicant: Hengdian Group DMEGC Magnetics Co., Ltd., Dongyang, Zhejiang 322118 (CN)
(72) Inventor: CHEN, Weikang, Jinhua, Zhejiang, 322118 (CN); DU, Qingshan, Jinhua, Zhejiang, 322118 (CN); JI, Xiaofan, Jinhua, Zhejiang, 322118 (CN); WANG, Wenrui, Jinhua, Zhejiang, 322118 (CN); WANG, Bangxiang, Jinhua, Zhejiang, 322118 (CN); REN, Yong, Jinhua, Zhejiang, 322118 (CN)
(74) Representative: Viering, Jentschura & Partner mbB Patent- und Rechtsanwälte

(57) **Abstract**

A solar cell, a method for preparing the same and an electrical device are provided. The method for preparing the solar cell includes following steps: providing a substrate, which includes a first surface and a second surface opposite to the first surface; forming a protective material layer on the first surface, and removing part of the protective material layer on a preset first doped region to prepare a protective layer; performing a first doping process in the preset first doped region on the substrate to prepare a substrate including a first doped region. A width of the first doped region is in a range of 10 µm to 35 µm.

## Description

### TECHNICAL FIELD

The present application relates to the field of batter technology, in particular to a solar cell, a method for preparing the same and an electrical device.

### BACKGROUND

Currently, the PERC solar cells in the market cannot meet the pursuit of higher energy conversion efficiency and power, so concepts of TOPCon high-efficiency solar cell appeared in 2013. After continuous research and development, the TOPCon cells have become relatively mature, taking into account both cost and efficiency. The large-scale mass production of the TOPCon cells are regarded as the beginning of the first year of industrialization of N-type cells, from which the TOPCon cells gradually replace the mainstream position of PERC cells in the market. For a technical effect of back passivation contact, the N-TOPCon cells has more market value than the PERC cells, the theoretical conversion efficiency of the N-TOPCon cells is higher than that of the PERC cells, and the price of the N-TOPCon cells is approaching that of the PERC cells. The TOPCon cells are less affected by weather, especially in terms of spectral response, both long-wave response of the TOPCon cells and short-wave response of the TOPCon cells are extremely good. Compared with the PERC cells, which only respond to short-wave, the TOPCon cells have a great space in spectral response, which can guarantee the continuous output of power generation. At the same time, the TOPCon cell has the advantages of low attenuation, high bifaciality rate, low temperature coefficient and the like, and the power generation improvement in the terminal power station is obvious.

The TOPCon cells technology is a type of tunnel oxide passivated contact solar cell technology based on the selective current carrier principle, which on the one hand, is derived from the different potential well heights of the valence bands and conduction bands relative to electron holes and electrons; and on the other hand, is derived from the different effective masses of electron holes and electrons. Overlaying ultrathin oxide tunnel layer and doped polycrystalline silicon layers can realize electron penetration and electron hole blocking, which result in excellent chemical passivation and field passivation. in conventional TOPCon cells, an N-type silicon wafers is used as a substrate, and full-surface boron diffusion is performed on the front side of the substrate, forming a PN junction on the front side of the cell, and realizing splitting of an exciton to a pair of electron and electron hole by construction of a built-in electric field. However, in the context of conventional technology, the boron diffusion on the full front surface of TOPCon cell structure, even with oxidation annealing, the lattice loss on the front surface of the cell is still unavoidable, and this loss will form a large number of composite centers, resulting in the loss of open-circuit voltage of the cell as well as a decrease in photoelectric conversion efficiency, which will affect the performance of the cell.

### SUMMARY

In view of above, in order to reduce lattice loss caused by preparing a doped layer and improve an open-circuit voltage and photoelectric conversion efficiency of the cell, the present application provides a solar cell, a method for preparing the same and an electric device.

A method for preparing a solar cell is provided, which includes following steps:
providing a substrate, which includes a first surface and a second surface opposite to the first surface;
forming a protective material layer on the first surface, and removing a part of the protective material layer on a preset first doped region to prepare a protective layer;
performing a first doping process in the preset first doped region on the substrate to prepare a substrate including a first doped region, wherein a width of the first doped region is in a range of 10 µm to 35 µm; and
removing the protective layer and preparing a passivated contact structure on the second surface.

In some embodiments, before the step of forming the protective material layer on the first surface, the method further includes a step of texturing the substrate.

In some embodiments, after the step of removing the part of the protective material layer on the preset first doped region to prepare the protective layer, and before the step of performing the first doping process in the preset first doped region on the substrate to prepare the substrate including the first doped region, the method further includes a step of subjecting the substrate including the protective layer to a first washing process.

Conditions for the first washing process includes: a cleaning liquid for the first washing process includes 1% to 6% of a strong monobasic alkali by mass, 0.5% to 2% of a texturing additive by mass, and 93% to 98.5% of a first solvent by mass; a time of the first washing process is in a range of 150 s to 350 s; and a temperature of the first washing process is in a range of 60 °C to 80 °C.

In some embodiments, a material of the protective layer is selected from the group consisting of silicon oxide, silicon nitride, photo-sensitive glue, and any combination thereof.

In some embodiments, the step of removing the protective layer includes a step of subjecting the substrate including the first doped region to a second washing process.

Conditions for the second washing process includes: washing the substrate including the first doped region with a hydrofluoric acid solution for 150s to 350s, and a percentage of hydrofluoric acid in the hydrofluoric acid solution is in a range of 40% to 80%.

In some embodiments, a surface concentration of the first doped region is in a range of 10¹⁹ to 3×10²⁰, and a sheet resistance of the first doped region is in a range of 40 S2 to 170 S2.

In some embodiments, after the step of preparing the passivated contact structure on the second surface, the method further includes: preparing a first passivation layer and a first anti-reflection layer stacked on the first surface; and preparing a second anti-reflection layer on the passivated contact structure.

In some embodiments, after the step of preparing the first passivation layer and the first anti-reflection layer stacked on the first surface and preparing the second anti-reflection layer on the passivated contact structure, the method further includes: preparing a first electrode penetrating through the first passivation layer and the first anti-reflection layer and connecting to the first doped region, and preparing a second electrode penetrating through the second anti-reflection layer and connecting to the passivated contact structure.

A solar cell prepared by the method described above is also provided in the present application.

An electrical device is also provided by the present application, which includes the solar cell described above and the solar cell is configured as a power source of the electrical device.

Compared with a method for preparing a passivated contact cell in conventional art, a first surface of a substrate in the present application is optimized by preparing a local first doped region, so that a first doping source diffuses locally in the first substrate. Thus, lattice loss on the front surface of the solar cell is avoided, and a photoelectric conversion efficiency of the cell is higher. On the basis of guaranteeing short current and fill factor, loss of open-circuit voltage caused by lattice distortion on the front surface of the cell is lowered, so that the conversion efficiency of the cell is improved.

### BRIEF DESCRIPTION OF THE DRAWINGS

FIG. 1 is a structural schematic diagram of a solar cell in an embodiment of the present application.
FIG. 2 is a top view of a first surface before preparing a passivated contact structure in an embodiment of the present application, in which (a) represents a first doped region with a textured structure, and (b) represents a first surface with a textured structure.

In the figures, 10 represents a solar cell; 100 represents a substrate; 1101 represents a tunnel oxide layer; 1102 represents a doped polysilicon layer; 110 represents a passivated contact structure; 120 represents a first passivation layer; 130 represents a first anti-reflection layer; 140 represents a second anti-reflection layer; 150 represents a first electrode; and 160 represents a second electrode.

### DETAILED DESCRIPTION

In order to facilitate understanding of the present application, the application will be described more fully below with reference to the relevant accompanying drawings. Preferred embodiments of the present application are given in the accompanying drawings. However, the present application can be realized in many different forms and is not limited to the embodiments described herein. Rather, these embodiments are provided to enable a more thorough and comprehensive understanding of the application of the present application.

Furthermore, the terms "first" and "second" are used for descriptive purposes only and are not to be understood as indicating or implying relative importance or implicitly specifying the number of indicated technical features. Thus, a feature defined with the terms "first", "second" may expressly or implicitly include at least one such feature. In the description of the invention, "plurality" means at least two, e.g., two, three, etc., unless otherwise expressly and specifically limited. In the description of the present application, "several" means at least one, e.g., one, two, etc., unless otherwise expressly and specifically limited.

The words "preferably," "more preferably," and the like in the present application refer to embodiments of the present application that, in certain embodiments, may provide certain beneficial effects. However, other embodiments may be preferred in the same or other cases. Moreover, the expression of one or more preferred embodiments does not imply that other embodiments are not available, nor is it intended to exclude other embodiments from the scope of the present application.

When a range of values is disclosed herein, said range is considered to be continuous and includes a minimum value and a maximum value of the range, as well as each value between such minimum and maximum values. Further, when the range refers to an integer, it includes each integer between the minimum and maximum values of the range. In addition, when multiple ranges are provided to describe a characteristic or feature, the ranges may be combined. In other words, unless otherwise indicated, all ranges disclosed herein should be understood to include any and all sub-ranges subsumed therein.

In describing positional relationships, unless otherwise specified, when an element such as a layer, membrane, or substrate is referred to as being "on" another membrane layer, it can be directly on the other membrane layer or an intermediate membrane layer can also be present. Further, when a layer is said to be "under" another layer, it may be directly underneath, or there may be one or more intermediate layers. It will also be appreciated that when a layer is referred to as being "between" two layers, it may be the only layer between the two layers, or one or more intermediate layers may be present.

Where "including", "having", and "comprising" are used as described herein, the intent is to cover non-exclusive inclusion. Unless explicit qualifying terms are used, such as "only," "consisted of" etc., another component may be added.

Unless mentioned to the contrary, a term in the singular form may include the plural form and is not to be understood as numbering one.

Unless otherwise defined, all technical and scientific terms used herein have the same meaning as commonly understood by those skilled in the art belonging to the present application. Terms used herein in the specification of the present application are used only for the purpose of describing specific embodiments and are not intended to limit the present application. The term "and/or" as used herein includes any and all combinations of one or more of the relevant listed items.

The present application provides a method for preparing a solar cell, including the following steps:
providing a substrate, which includes a first surface and a second surface opposite to the first surface;
forming a protective material layer on the first surface, and removing part of the protective material layer on a preset first doped region to prepare a protective layer;
performing a first doping process in the preset first doped region on the substrate to prepare a substrate including a first doped region, wherein a width of the first doped region is in a range of 10 µm to 35 µm; and
removing the protective layer and preparing a passivated contact structure on the second surface.

Furthermore, a width of the first doped region can be but is not limited to be 10 µm, 12 µm, 14 µm, 15 µm, 16 µm, 18 µm, 19 µm, 20 µm, 21 µm, 22 µm, 24 µm, 26 µm, 28 µm, 29 µm, 30 µm, 31 µm, 32 µm, 34 µm or 35 µm. Optionally, a width of the first doped region is in a range of 15 µm to 30 µm.

In an embodiment, before the step of forming the protective material layer on the first surface, the method further includes a step of texturing the substrate.

The step of texturing the substrate can be but is not limited to texturing one of the first surface and the second surface of the substrate, or texturing both surfaces of the substrate. Optionally, the first surface of the substrate is textured.

It could be understood that a texturing solution includes 0.6% to 2.0% of strong monobasic alkali, 0.3% to 1.0% of texturing additive and 97% to 99% of second solvent by mass. A time of the texturing process is in a range of 350s to 550s, and a temperature of the texturing process is in a range of 70 °C to 85 °C.

In one embodiment, a material of the protective layer is selected from the group consisting of silicon oxide, silicon nitride, photo-sensitive glue, and any combination thereof.

Specifically, the photo-sensitive glue can be but is not limited to be selected from a group consisting of ma-N 400, NR9-6000PY, N5735-L0(N244), and any combination thereof.

It could be understood that the method for preparing the protective layer can be but is not limited to be selected from the group consisting of a wet oxidation method, a dry oxidation method, an LPCVD method, a high temperature oxidation method in a tube furnace, and any combination thereof.

Furthermore, a material of the protective layer is silicon oxide. Specifically, the silicon oxide is prepared by the high temperature oxidation method in a tube furnace, a temperature for preparing the silicon oxide is in a range of 500 °C to 900 °C, a time for preparing the silicon oxide is in a range of 1500s to 5000s, a pressure for preparing the silicon oxide is in a range of 600 mbar to 1024mbar, and a thickness of the prepared silicon oxide is in a range of 5 nm to 20 nm.

Specifically, a width of the silicon oxide can be but is not limited to be 5nm, 6 nm, 7 nm, 8nm, 9 nm, 10 nm, 11 nm, 12 nm, 13 nm, 14 nm, 15 nm, 16 nm, 17 nm, 18 nm, 19 nm or 20 nm.

In an embodiment, a temperature for preparing the silicon oxide as the protective layer material can be but is not limited to be 500 °C, 550 °C, 600 °C, 650 °C, 700 °C, 750 °C, 800 °C, 850 °C or 900 °C; a time for preparing the silicon oxide as the protective layer material can be but is not limited to be 1500 s, **2000** s, 2500 s, 3000 s, 3500 s, 4000 s, 4500 s or 5000 s; and, a pressure for preparing the silicon oxide as the protective layer material can be but is not limited to be 600 mbar, 700 mbar, 800 mbar, 900 mbar, 1000 mbar or 1024 mbar.

The protective layer can effectively avoid lattice distortion caused in the process of doping the first surface of the substrate, which effectively realize local graphical doping and realize well ohmic contact, so that the number of composite centers is reduced, and the conversion efficiency of the cell is increased.

In an embodiment, part of the protective material layer on the preset first doped region is removed by means of laser. The conditions of the laser treatment includes: a rated power of the laser treatment is in a range of 15W to 45W, a frequency of the laser treatment is in a range of 300KHz to 950KHz, a spot size of the laser treatment is in a range of 10 µm to 35 µm, and a void-solid ratio of the laser treatment is in a range of 0.2:0.5 to 0.4:0.5.

Specifically, the rated power of the laser treatment can be but is not limited to be 15 W, 17W, 20W, 22 W, 24 W, 26 W, 28 W, 30W, 32 W, 34 W, 36 W, 38 W, 40W, 42 W or 45 W; the frequency of the laser treatment can be but is not limited to be 300KHz, 350KHz, 400 KHz, 450KHz, 500KHz, 550KHz, 600KHz, 650KHz, 700KHz, 750KHz, 800KHz, 850KHz, 900KHz or 950KHz; the spot size of the laser treatment can be but is not limited to be 10 µm, 12 µm, 14 µm, 15 µm, 16 µm, 18 µm, 19 µm, 20 µm, 21 µm, 22 µm, 24 µm, 26 µm, 28 µm, 29 µm, 30 µm, 31 µm, 32 µm, 34 µm or 35 µm; and, the void-solid ratio of the laser treatment can be but is not limited to be 0.2:0.5, 0.25:0.5, 0.3:0.5 or 0.4:0.5. Optionally, the rated power of the laser treatment is in a range of 20w to 40w, the frequency of the laser treatment is in a range of 350KHz to 900KHz, and the spot size of the laser treatment is in a range of 15 µm to 30 µm.

In an embodiment, after the step of removing part of the protective material layer on the preset first doped region to prepare the protective layer, and before the step of performing the first doping process in the preset first doped region on the substrate to prepare the substrate including the first doped region, the method further includes a step of subjecting the substrate including the protective layer to a first washing process.

In an embodiment, conditions for the first washing process includes: a cleaning liquid for the first washing process includes 1% to 6% of a strong monobasic alkali by mass, 0.5% to 2% of a texturing additive by mass and 93% to 98.5% of a first solvent by mass; a time of the first washing process is in a range of 150 s to 350 s; and a temperature of the first washing process is in a range of 65 °C to 75 °C. Optionally, the cleaning liquid for the first washing process includes 1.4% to 5% of a strong monobasic alkali by mass, 0.9% to 1.5% of a texturing additive by mass and 93.5% to 98% of the first solvent by mass; the time of the first washing process is in a range of 200 s to 300 s; and the temperature of the first washing process is in a range of 65 °C to 75 °C.

Specifically, the time of the first washing process can be but is not limited to be 200s, 210s, 220s, 230s, 240s, 250s, 260s, 270s, 280s, 290s or 300s, and the temperature of the first washing process can be but is not limited to be 65 °C, 66 °C, 67 °C, 68 °C, 69 °C, 70 °C, 71 °C, 72 °C, 73 °C, 74 °C or 75 °C.

In an embodiment, strong monobasic alkali can be but is not limited to be selected from the group consisting of potassium hydroxide, sodium hydroxide, and any combination thereof. Each of the first solvent and the second solvent can independently be but is not limited to be water. It could be understood that the water herein is deionized water.

It could be understood that the first washing process herein can remove the lattice loss caused in by the laser treatment.

In an embodiment, a surface concentration of the first doped region is in a range of 1.5×10¹⁹ to 2.5×10²⁰, and a sheet resistance of the first doped region is in a range of 60 S2 to 150 Ω.

Furthermore, the surface concentration of the first doped region is in a range of 10¹⁹ to 3×10²⁰, and the sheet resistance of the first doped region is in a range of 40 S2 to 170 S2. Optionally, the surface concentration of the first doped region can be but is not limited to be 1.5×10¹⁹, 3×10¹⁹, 4.5×10¹⁹, 6×10¹⁹, 7.5×10¹⁹, 9×10¹⁹ , 1.05×10²⁰, 1.2×10²⁰, 1.35×10²⁰, 1.5×10²⁰, 1.65×10²⁰, 1.8×10²⁰, 1.95×10²⁰, 2.1×10²⁰, 2.25×10²⁰, 2.4×10²⁰ or 2.5×10²⁰. The sheet resistance of the first doped region can be but is not limited to be 60 S2, 70 S2, 80 S2, 90 S2, 100 S2, 110 S2, 120 S2, 130 S2, 140 S2 or 150 Ω.

Furthermore, a diffusion temperature for preparing the first doped region is in a range of 900 °C to 1100 °C, and a diffusion time for preparing the first doped region is in a range of 300 s to 700 s.

Specifically, the diffusion temperature for preparing the first doped region can be but is not limited to be 900 °C, 950 °C, 1000 °C, 1050 °C or 1100 °C, and the diffusion time for preparing the first doped region can be but is not limited to be 300s, 350 s, 400 s, 450 s, 500 s, 550 s, 600 s, 650 s or 700 s.

Furthermore, the step of removing the protective layer includes a step of subj ecting the substrate including the first doped region to a second washing process. In an embodiment, conditions for the second washing process includes: washing the substrate including the first doped region with a hydrofluoric acid solution for 150s to 350s, and a percentage of hydrofluoric acid in the hydrofluoric acid solution is in a range of 40% to 80%. Optionally, conditions for the second washing process includes: washing the substrate including the first doped region with a hydrofluoric acid solution for 180 s to 300 s, and a percentage of hydrofluoric acid in the hydrofluoric acid solution is in a range of 50% to 70%.

Specifically, a percentage of the hydrofluoric acid solution in the hydrofluoric acid can be but is not limited to be 50%, 55%, 60%, 65% or 70%, and a time of the second washing process can be but is not limited to be 180s, 200 s, 220 s, 240 s, 260 s, 280 s or 300 s.

It could be understood that in the second washing process, not only the protective layer can be removed, but also the glass layer on the first doped region can be removed.

In an embodiment, after the step of preparing the passivated contact structure on the second surface, the method further includes a step of preparing a first passivation layer and a first anti-reflection layer stacked on the first surface, and preparing a second anti-reflection layer on the passivated contact structure.

Furthermore, a material of the first passivation layer can be but is not limited to be selected from the group consisting of aluminum oxide, gallium oxide, and any combination thereof. Each of a material of the first anti-reflection layer and a material of the second anti-reflection layer is independently selected from the group consisting of silicon nitride, silicon oxynitride, silicon oxide, and any combination thereof.

Furthermore, the passivated contact structure sequentially includes a tunnel oxide layer and a doped polysilicon layer stacked together, and the tunnel oxide layer contacts with the substrate.

In an embodiment, after the step of preparing the first passivation layer and the first anti-reflection layer stacked on the first surface and preparing the second anti-reflection layer on the passivated contact structure, the method further includes a step of preparing a first electrode penetrating through the first passivation layer and the first anti-reflection layer and connecting to the first doped region, and preparing a second electrode penetrating through the second anti-reflection layer and connecting to the passivated contact structure.

Compared with a method for preparing a passivated contact cell in conventional art, a first surface of a substrate in the present application is optimized by preparing a local first doped region, so that a first doping source diffuses locally in the first substrate. Thus, lattice loss on the front surface of the solar cell is avoided, and a photoelectric conversion efficiency of the cell is higher. On the basis of guaranteeing short current and fill factor, loss of open-circuit voltage caused by lattice distortion on the front surface of the cell is lowered, so that the conversion efficiency of the cell is improved.

A solar cell prepared by the method described above is also provided in the present application.

Furthermore, an electrical device is also provided by the present application, which includes the solar cell described above and the solar cell is configured as a power source of the electrical device. It could be understood that the electrical device can be but is not limited to transformers, electric reactors, capacitors, composite apparatus, circuit breakers, transformers, lightning arresters, coupling capacitors, transmission lines, power cables, grounding devices, electric generators, rotary condensers, electromotors, enclosed busbars or thyristors.

The following specific embodiments are provided to illustrate the solar cell of the present application and the preparation method thereof in further detail. The raw materials involved in the following specific embodiments may be commercially available unless otherwise specified.

### First embodiment

The present embodiment provided a solar cell and a method for preparing the same, and the method included the following steps.

An N-type substrate was provided, and a first surface of the N-type substrate was textured. Conditions of texturing treatment included: a texturing solution included 2.0% of sodium hydroxide, 0.3% of texturing additive and 97.7% of water; a time of the texturing process was 550 s, and a temperature of the texturing process was 85 °C.

The textured N-type substrate was placed in a tube furnace and subjected to bifacial silicon oxide layer generation, a temperature of the bifacial silicon oxide layer generation was 900 °C, a time of the bifacial silicon oxide layer generation was 5000s, a pressure of the bifacial silicon oxide layer generation was 1024 mbar, and a silicon oxide layer having a width of 20 nm was obtained.

The silicon substrate with the silicon oxide layer was subjected to a laser treatment to remove part of the protective material layer in the first doped region. A rated power of the laser treatment was 40W, a frequency of the laser treatment was 900KHz, a spot size of the laser treatment was 30 µm, and a void-solid ratio of the laser treatment was 0.3:0.5.

After the laser treatment, the silicon substrate was put in a texturing machine and subj ected to a first washing process. A cleaning liquid for the first washing process included 5% of sodium hydroxide by mass, 1.4% of a texturing additive by mass and 93.6% of water by mass; a temperature of the first washing process was 75 °C; and a time of the first washing process was 300 s. Then, the obtained silicon substrate was washed with a HCl solution to remove the residual alkali-containing cleaning liquid.

After the first cleaning liquid, the silicon substrate was subjected to boron diffusion. A temperature of the boron diffusion was 1050 °C, a time of the boron diffusion was 700s, a surface concentration of the silicon substrate after the boron diffusion was 2.5e²⁰, and a sheet resistance of the silicon substrate was controlled as 60 Ω.

After the boron diffusion, the silicon substrate was subjected to a BSG and protective layer washing process, i.e., subjected to a second washing process. Conditions of the second washing process included: washing the substrate including the silicon substrate with a hydrofluoric acid solution for 300 s, and a percentage of hydrofluoric acid in the hydrofluoric acid solution was 70%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

### Second embodiment

The present embodiment provided a solar cell and a method for preparing the same, and the method included the following steps.

An N-type substrate was provided, and a first surface of the N-type substrate was textured. Conditions of texturing treatment included: a texturing solution included 0.6% of sodium hydroxide, 1.0% of texturing additive and 98.4% of water; a time of the texturing process was 350 s, and a temperature of the texturing process was 70 °C.

The textured N-type substrate was placed in a tube furnace and subjected to bifacial silicon oxide layer generation, a temperature of the bifacial silicon oxide layer generation was 500 °C, a time of the bifacial silicon oxide layer generation was 1500 s, a pressure of the bifacial silicon oxide layer generation was 600 mbar, and a silicon oxide layer having a width of 5 nm was obtained.

The silicon substrate with the silicon oxide layer was subjected to a laser treatment to remove part of the protective material layer in the first doped region. A rated power of the laser treatment was 20W, a frequency of the laser treatment was 350KHz, a spot size of the laser treatment was 15 µm, and a void-solid ratio of the laser treatment was 0.2:0.5.

After the laser treatment, the silicon substrate was put in a texturing machine and subjected to a first washing process. A cleaning liquid for the first washing process included 1.5% of sodium hydroxide by mass, 0.9% of a texturing additive by mass and 97.6% of water by mass; a temperature of the first washing process was 65 °C; and a time of the first washing process was 200 s. Then, the obtained silicon substrate was washed with a HCl solution to remove the residual alkali-containing cleaning liquid.

After the first cleaning liquid, the silicon substrate was subjected to boron diffusion. A temperature of the boron diffusion was 950 °C, a time of the boron diffusion was 300s, a surface concentration of the silicon substrate after the boron diffusion was 1.5e¹⁹, and a sheet resistance of the silicon substrate was controlled as 150 Ω.

After the boron diffusion, the silicon substrate was subjected to a BSG and protective layer washing process, i.e., subjected to a second washing process. Conditions of the second washing process included: washing the substrate including the silicon substrate with a hydrofluoric acid solution for 180 s, and a percentage of hydrofluoric acid in the hydrofluoric acid solution was 50%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

### Third embodiment

The present embodiment provided a solar cell and a method for preparing the same, and the method included the following steps.

An N-type substrate was provided, and a first surface of the N-type substrate was textured. Conditions of texturing treatment included: a texturing solution included 1.4% of sodium hydroxide, 0.4% of texturing additive and 98.2% of water; a time of the texturing process was 450 s, and a temperature of the texturing process was 80 °C.

The textured N-type substrate was placed in a tube furnace and subjected to bifacial silicon oxide layer generation, a temperature of the bifacial silicon oxide layer generation was 750 °C, a time of the bifacial silicon oxide layer generation was 3000 s, a pressure of the bifacial silicon oxide layer generation was 800 mbar, and a silicon oxide layer having a width of 12 nm was obtained.

The silicon substrate with the silicon oxide layer was subjected to a laser treatment to remove part of the protective material layer in the first doped region. A rated power of the laser treatment was 20W, a frequency of the laser treatment was 350KHz, a spot size of the laser treatment was 20 µm, and a void-solid ratio of the laser treatment was 0.4:0.5.

After the laser treatment, the silicon substrate was put in a texturing machine and subjected to a first washing process. A cleaning liquid for the first washing process included 3% of sodium hydroxide by mass, 1.1% of a texturing additive by mass and 95.9% of water by mass; a temperature of the first washing process was 72 °C; and a time of the first washing process was 250 s. Then, the obtained silicon substrate was washed with a HCl solution to remove the residual alkali-containing cleaning liquid.

After the first cleaning liquid, the silicon substrate was subjected to boron diffusion. A temperature of the boron diffusion was 1000 °C, a time of the boron diffusion was 500s, a surface concentration of the silicon substrate after the boron diffusion was 7e¹⁹, and a sheet resistance of the silicon substrate was controlled as 100 Ω.

After the boron diffusion, the silicon substrate was subjected to a BSG and protective layer washing process, i.e., subjected to a second washing process. Conditions of the second washing process included: washing the substrate including the silicon substrate with a hydrofluoric acid solution for 240 s, and a percentage of hydrofluoric acid in the hydrofluoric acid solution was 60%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

### First comparative embodiment

The present comparative embodiment provided a solar cell and a method for preparing the same, and the method included the following steps.

An N-type substrate was provided, and a first surface of the N-type substrate was textured. Conditions of texturing treatment included: a texturing solution included 2.0% of sodium hydroxide, 0.3% of texturing additive and 97.7% of water; a time of the texturing process was 550 s, and a temperature of the texturing process was 85 °C.

The silicon substrate was subjected to boron diffusion. A temperature of the boron diffusion was 1050 °C, a time of the boron diffusion was 700s, a surface concentration of the silicon substrate after the boron diffusion was 2.5e²⁰, and a sheet resistance of the silicon substrate was controlled as 60 Ω.

After the boron diffusion, the silicon substrate was subjected to a BSG washing process. Conditions of the BSG washing process included: washing the substrate with a HF solution for 300 s, and a percentage of hydrofluoric acid in the hydrofluoric acid solution was 70%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

### Second comparative embodiment

The present comparative embodiment provided a solar cell and a method for preparing the same, and the method included the following steps.

An N-type substrate was provided, and a first surface of the N-type substrate was textured. Conditions of texturing treatment included: a texturing solution included 0.6% of sodium hydroxide, 1.0% of texturing additive and 98.4% of water; a time of the texturing process was 350 s and a temperature of the texturing process was 70 °C.

The silicon substrate was subjected to boron diffusion. A temperature of the boron diffusion was 950 °C, a time of the boron diffusion was 300 s, a surface concentration of the silicon substrate after the boron diffusion was 1.5e¹⁹, and a sheet resistance of the silicon substrate was controlled as 150 Ω.

After the boron diffusion, the silicon substrate was subjected to a BSG washing process. Conditions of the BSG washing process included: washing the substrate with a HF solution for 180 s, and a percentage of hydrofluoric acid in the hydrofluoric acid solution was 50%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

### Third comparative embodiment

The present comparative embodiment provided a solar cell and a method for preparing the same, and the method included the following steps.

An N-type substrate was provided, and a first surface of the N-type substrate was textured. Conditions of texturing treatment included: a texturing solution included 1.2% of sodium hydroxide, 0.5% of texturing additive and 98.2% of water; a time of the texturing process was 450 s and a temperature of the texturing process was 80 °C.

The N-type substrate was placed in a tube furnace and subjected to bifacial silicon oxide layer generation, a temperature of the bifacial silicon oxide layer generation was 750 °C, a time of the bifacial silicon oxide layer generation was 3000 s, a pressure of the bifacial silicon oxide layer generation was 800 mbar, and a silicon oxide layer having a width of 12 nm was obtained.

The silicon substrate with the silicon oxide layer was subjected to a laser treatment to remove part of the protective material layer in the first doped region. A rated power of the laser treatment was 20W, a frequency of the laser treatment was 350KHz, a spot size of the laser treatment was 40 µm, and a void-solid ratio of the laser treatment was 0.4:0.5.

After the laser treatment, the silicon substrate was put in a texturing machine and subjected to a washing process. A cleaning liquid for included 3% of sodium hydroxide by mass, 1.1% of a texturing additive by mass and 95.9% of water by mass; a temperature of the washing process was 72 °C; and a time of the first washing process was 250 s. Then, the obtained silicon substrate was washed with a HCl solution to remove the residual alkali-containing cleaning liquid.

The silicon substrate was subjected to boron diffusion. A temperature of the boron diffusion was 1000 °C, a time of the boron diffusion was 500 s, a surface concentration of the silicon substrate after the boron diffusion was 7e¹⁹, and a sheet resistance of the silicon substrate was controlled as 100 Ω.

After the boron diffusion, the silicon substrate was subjected to a BSG washing process. Conditions of the BSG washing process included: washing the substrate with a HF solution for 240 s, and a percentage of hydrofluoric acid in the hydrofluoric acid solution was 60%.

A passivated contact structure was prepared on a second surface of the N-type substrate.

Aluminum oxide was prepared on the first surface of the N-type substrate as a first passivation layer, and silicon nitride was prepared on a first surface of the N-type substrate as the first anti-reflection layer. Silicon nitride was prepared on the second surface of the N-type substrate as a second anti-reflection layer.

A silver-aluminum electrode penetrating through the first passivation layer and the first anti-reflection layer and connecting to the first doped region was prepared as a first electrode, and a silver electrode penetrating through the second anti-reflection layer and connecting to the passivated contact structure was prepared as a second electrode.

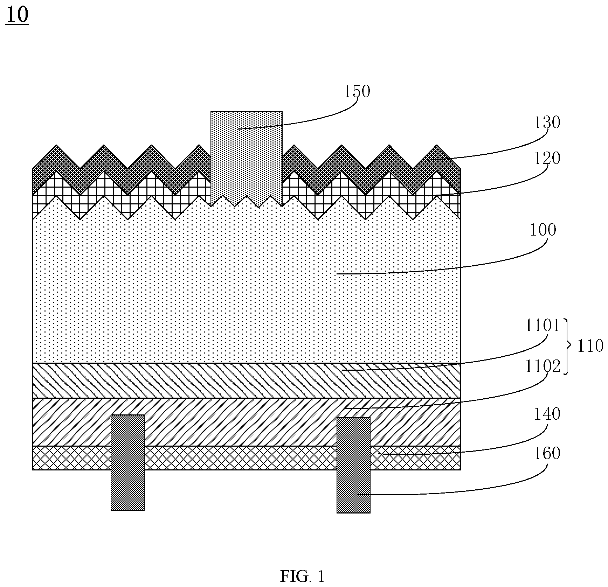

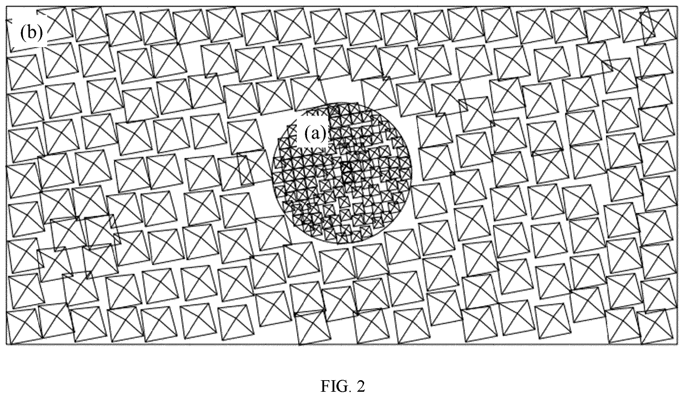

FIG. 1 shows a structure of a solar cell 10 provided in the embodiment. The solar cell 10 included a substrate 100. One side of the substrate 100 was provided with a first doped region, and a side of the substrate 100 away from the first doped region was provided with a passivated contact structure 110 and a second anti-reflection layer 140. The passivated contact structure 110 included a tunnel oxide layer 1101 and a doped polysilicon layer 1102. The surface of the substrate 100 including the first doped region was provided with a first passivation layer 120 and a first anti-reflection layer 130. The first electrode 150 was in contact with the first doped region in the substrate 100, and the second electrode 160 was in contact with the doped polysilicon layer 1102. FIG. 2 was a top view of the first surface of the substrate 100 before preparing a passivated contact structure 110, in which (a) represented the first doped region with the textured structure, and (b) represented the first surface of the substrate 100 with the textured structure. After three times of batch experiments, a final product battery piece of the silicon wafer was tested, and an efficiency (Eta) of the battery piece, a short-circuit current (Isc) of the battery piece, an open-circuit voltage (Uoc) of the battery piece and a fill factor (FF) of the battery piece was shown in the table herein.

**Table 1**

| | Eta | Uoc(V) | Isc(A) | FF |
|---|---|---|---|---|
| First Embodiment | 23.71 | 0.7049 | 13.653 | 81.34 |
| Second Embodiment | 23.72 | 0.7052 | 13.652 | 81.33 |
| Third Embodiment | 23.76 | 0.7054 | 13.658 | 81.43 |
| First Comparative Embodiment | 23.68 | 0.7033 | 13.657 | 81.39 |
| Second Comparative Embodiment | 23.70 | 0.7039 | 13.660 | 81.38 |
| Third Comparative Embodiment | 23.65 | 0.7036 | 13.646 | 81.32 |

Referring to Table 1, comparing the embodiments to the comparative embodiments, the efficiency Eta of the battery piece improved by 0.01 to 0.08, the improvement was mainly brought by improvement of the open-circuit voltage (Uoc) of the battery piece, which improved by 1.6mV to 2.1mV. However, the fill factor FF of the battery piece lost by 0.06. It could be concluded that in conventional art, a first surface of a substrate in the present application was in the first substrate. Thus, lattice loss on the front surface of the solar cell was avoided, and a photoelectric conversion efficiency of the cell was higher. On the basis of guaranteeing short current and fill factor, loss of open-circuit voltage caused by lattice distortion on the front surface of the cell was lowered, so that the conversion efficiency of the cell was improved.

The various technical features of the above embodiments may be combined in any combination, and for the sake of brevity of description, not all possible combinations of the various technical features of the above embodiments have been described. However, as long as the combinations of these technical features are not contradictory, they should be considered to be within the scope of the present specification.

The above-described embodiments only express several embodiments of the present application to facilitate a specific and detailed understanding of the technical solution of the present application, but they are not to be construed as a limitation on the scope of protection of the present application. It should be noted that, for a person of ordinary skill in the art, several deformations and improvements can be made without departing from the conception of the present application, all of which fall within the scope of protection of the present application. It should be understood that the technical solutions obtained by the person skilled in the art through logical analysis, reasoning or limited experimentation on the basis of the technical solutions provided in the present application are within the scope of protection of the claims appended to the present application. Therefore, the scope of protection of the patent application shall be subject to the contents of the appended claims, and the specification may be used to interpret the contents of the claims.

## Claims

1. A method for preparing a solar cell (10), **characterized by** comprising following steps,
providing a substrate (100), which comprises a first surface and a second surface opposite to the first surface;
forming a protective material layer on the first surface, and removing a part of the protective material layer on a preset first doped region to prepare a protective layer;
performing a first doping process in the preset first doped region on the substrate (100) to prepare a substrate (100) comprising a first doped region, wherein a width of the first doped region is in a range of 10 µm to 35 µm; and
removing the protective layer and preparing a passivated contact structure (110) on the second surface.

2. The method of claim 1, wherein before the step of forming the protective material layer on the first surface, the method further comprises a step of texturing the substrate (100).

3. The method of claim 2, wherein conditions for the step of texturing the substrate (100) comprises: a texturing solution comprises 0.6% to 2.0% of strong monobasic alkali, 0.3% to 1.0% of texturing additive and 97% to 99% of second solvent by mass;
a time of the step of texturing the substrate (100) is in a range of 350s to 550s, and
a temperature of the step of texturing the substrate (100) is in a range of 70 °C to 85 °C.

4. The method of claim 2, wherein the step of removing the part of the protective material layer on the preset first doped region to prepare the protective layer comprises: removing the part of the protective material layer on the preset first doped region to prepare the protective layer by means of laser treatment, conditions of the laser treatment comprises: a rated power of the laser treatment is in a range of 15W to 45W, a frequency of the laser treatment is in a range of 300KHz to 950KHz, a spot size of the laser treatment is in a range of 10 µm to 35 µm, and a void-solid ratio of the laser treatment is in a range of 0.2:0.5 to 0.4:0.5.

5. The method of claim 1, wherein after the step of removing the part of the protective material layer on the preset first doped region to prepare the protective layer, and before the step of performing the first doping process in the preset first doped region on the substrate (100) to prepare the substrate (100) comprising the first doped region, the method further comprises a step of subjecting the substrate (100) comprising the protective layer to a first washing process, wherein conditions for the first washing process comprises: a cleaning liquid for the first washing process comprises 1% to 6% of a strong monobasic alkali by mass, 0.5% to 2% of a texturing additive by mass, and 93% to 98.5% of a first solvent by mass;
a time of the first washing process is in a range of 150 s to 350 s; and
a temperature of the first washing process is in a range of 60 °C to 80 °C.

6. The method of claim 1, wherein a material of the protective layer is selected from the group consisting of silicon oxide, silicon nitride, photo-sensitive glue, and any combination thereof.

7. The method of claim 1, wherein the step of removing the protective layer comprises a step of subj ecting the substrate (100) comprising the first doped region to a second washing process; conditions for the second washing process comprises: washing the substrate (100) comprising the first doped region with a hydrofluoric acid solution for 150 s to 350 s, and a percentage of hydrofluoric acid in the hydrofluoric acid solution is in a range of 40% to 80%.

8. The method of claim 1, wherein a surface concentration of the first doped region is in a range of 10¹⁹ to 3×10²⁰, and a sheet resistance of the first doped region is in a range of 40 S2 to 170 S2.

9. The method of any one of claims 1 to 8, wherein after the step of preparing the passivated contact structure (110) on the second surface, the method further comprises:
preparing a first passivation layer (120) and a first anti-reflection layer (130) stacked on the first surface; and
preparing a second anti-reflection layer (140) on the passivated contact structure (110).

10. The method of claim 9, wherein after the step of preparing the first passivation layer (120) and the first anti-reflection layer (130) stacked on the first surface and preparing the second anti-reflection layer (140) on the passivated contact structure (110), the method further comprises:
preparing a first electrode (150) penetrating through the first passivation layer (120) and the first anti-reflection layer (130) and connecting to the first doped region; and
preparing a second electrode (160) penetrating through the second anti-reflection layer (140) and connecting to the passivated contact structure (110).

11. A solar cell (10) prepared by the method of any one of claims 1 to 10, **characterized by** comprising:
a substrate (100), which comprises a first surface and a second surface opposite to the first surface;
a first doped region disposed on the first surface of the substrate (100), wherein a width of the first doped region is in a range of 10 µm to 35 µm;
a passivated contact structure (110) on the second surface of the substrate (100);
a first electrode (150); and
a second electrode (160).

12. The solar cell (10) of claim 11, wherein the passivated contact structure (110) sequentially comprises a tunnel oxide layer (1101) and a doped polysilicon layer (1102) stacked together, and the tunnel oxide layer (1101) contacts with the substrate (100).

13. The solar cell (10) of claim 11, further comprising a first passivation layer (120) and a first anti-reflection layer (130) stacked on the first surface, and a second anti-reflection layer (140) disposed on the passivated contact structure (110).

14. The solar cell (10) of claim 11, wherein the first electrode (150) penetrates through the first passivation layer (120) and the first anti-reflection layer (130) and connects to the first doped region, and the second electrode (160) penetrates through the second anti-reflection layer (140) and connects to the passivated contact structure (110).

15. An electrical device, **characterized by** comprising the solar cell (10) of any one of claims 11 to 14, wherein the solar cell (10) is configured as a power source of the electrical device.
